# EUROPEAN PATENT APPLICATION

(11) **EP 2 592 645 A2**
(43) Date of publication of application: **15.05.2013**
(21) Application number: 12191969.0
(22) Date of filing: 09.11.2012
(51) Int. Cl.: H01J 37/32

(54) **Substrate processing apparatus**

(30) Priority: 10.11.2011 JP 2011246852
(71) Applicant: TOKYO ELECTRON LIMITED, Minato-ku Tokyo 107-6325 (JP)
(72) Inventor: Hanawa, Kenichi, Yamanashi, 407-8511 (JP)
(74) Representative: HOFFMANN EITLE

(57) **Abstract**

A substrate processing apparatus includes a high frequency power supply configured to generate a high frequency power; a plasma generation electrode configured to generate the plasma by the high frequency power supplied from the high frequency power supply; a single matching unit provided between the high frequency power supply and the plasma generation electrode, and configured to match an impedance of a transmission path and an impedance of a load; and an impedance adjusting circuit provided between the matching unit and the plasma generation electrode, and configured to adjust an impedance therebetween. The matching unit performs impedance matching by setting the plasma and the impedance adjusting circuit as a single load, and an output impedance of the matching unit is adjusted to a value higher than an impedance of the plasma by adjusting the impedance by the impedance adjusting circuit.

## Description

### Field of the Invention

The present invention relates to a substrate processing apparatus configured as a parallel plate type plasma processing apparatus.

### Background of the Invention

Conventionally, there is known a parallel plate type plasma processing apparatus having a configuration in which anode/cathode electrodes are provided within a chamber and a high frequency power is supplied to the cathode electrode via a matching unit from a power source provided outside the chamber (see, e.g., Japanese Patent Application Publication S61-119686).

Typically, since an impedance of a plasma load ranges from about 1 Ω to several Ω, the matching unit needs to perform matching between an impedance (e.g., 50 Ω) of a transmission path and the low impedance (about 1 Ω to several Ω) of the plasma load.

In case that such parallel plate type plasma processing apparatus is applied to a plasma process of a large-size substrate for use in a solar cell panel or a flat panel, a great power is required. Further, when matching a high impedance with the low impedance of the plasma load as mentioned above, an output impedance from the matching unit becomes as low as the impedance of the plasma load. Accordingly, an electric current flowing in the matching unit and an electric current flowing from the matching unit may increase extremely, most likely resulting in a heat generation or a power loss. Further, if the output impedance is as low as stated above, a slight difference in the impedance generated due to a minute difference in assembling of the matching unit or the transmission path may result in a large variation in the impedance, leading in turn to a great deviation in the electric current. As a result, there may be caused a great fluctuation in the power inputted to the electrode.

Further, if the size of the substrate is enlarged, the electrode also needs to be scaled up. In this case, since the length of the electrode is no longer negligible for a high frequency wavelength, a standing wave or the like may be generated and, thus, it may become difficult to have a uniform voltage distribution. If the voltage distribution becomes non-uniform, a plasma density may also become non-uniform, having an adverse influence on a processing result of a product.

To solve this non-uniform problem, there are known a technique of supplying powers to both ends of the electrode via respective matching units (see, e.g., Japanese Patent Application Publication No. 2001-274099); a technique of supplying a power to both ends of the electrode after branching the power from a single matching unit (see, e.g., Japanese Patent Application Publication No. 2000-003878); and so forth. These techniques, however, could not solve the aforementioned problem caused by the small output impedance of the matching unit. That is, such problem still remains unsolved even if these techniques are applied. Further, in case that powers are supplied to both ends of the electrode via respective matching units, there may occur a matching failure due to interference between the two matching units because the two matching units are coupled to the same load. Furthermore, since the number of the matching units including two high-price variable capacitors for high current increases, an apparatus cost increases. Meanwhile, in case that a low-impedance output of a single matching unit is applied to both ends of the electrode after branched from the single matching unit, the length of a flow path in which a high frequency power of a high power level flows becomes long, resulting in a great power loss.

An effective measure to solve the problems caused by the low output impedance of the matching unit has yet to be developed. The techniques disclosed in Japanese Patent Application Publication Nos. 2001-274099 and 2000-003878 to achieve a uniform voltage distribution of the electrode are not appropriate.

### Summary of the Invention

In view of the above, the present invention provides a substrate processing apparatus capable of suppressing a deviation in an electric current due to a variation in impedance that can be caused by a heat generation or a power loss of a matching unit or a transmission path and a difference in assembling of the matching unit or the transmission path.

In addition, the present invention also provides a substrate processing apparatus capable of uniforming a voltage distribution of a large-size electrode corresponding to a large-size substrate without causing a power loss or a matching failure due to interference between matching units.

In accordance with a first aspect of the present invention, there is provided a substrate processing apparatus for processing a substrate by a plasma generated by a high frequency power, the apparatus including: a high frequency power supply configured to generate a high frequency power; a plasma generation electrode configured to generate the plasma by the high frequency power supplied from the high frequency power supply; a single matching unit provided between the high frequency power supply and the plasma generation electrode, and configured to match an impedance of a transmission path and an impedance of a load; and an impedance adjusting circuit provided between the matching unit and the plasma generation electrode, and configured to adjust an impedance therebetween.

The matching unit performs impedance matching by setting the plasma and the impedance adjusting circuit as a single load, and an output impedance of the matching unit is adjusted to a value higher than an impedance of the plasma by adjusting the impedance by the impedance adjusting circuit.

In the first aspect, the impedance adjusting circuit may have a single variable capacitor to adjust the impedance by using the variable capacitor. Moreover, the impedance adjusting circuit may further have one or more fixed capacitors to perform a fine adjustment of the impedance by using the fixed capacitors. The fixed capacitors may be selectively connectable by selecting one or more of the fixed capacitors among the fixed capacitors.

In accordance with a second aspect of the present invention, there is provided a substrate processing apparatus for processing a substrate by a plasma generated by a high frequency power, the apparatus including: a high frequency power supply configured to generate a high frequency power; a plasma generation electrode having a first power feed point and a second power feed point provided at an oppositely facing position to the first power feed point, and configured to generate the plasma by the high frequency power supplied to the first power feed point and the second power feed point from the high frequency power supply; a single matching unit provided between the high frequency power supply and the plasma generation electrode, and configured to match an impedance of a transmission path and an impedance of a load; a first impedance adjusting circuit provided between the matching unit and the first power feed point, and configured to adjust an impedance therebetween; and a second impedance adjusting circuit provided between the matching unit and the second power feed point, and configured to adjust an impedance therebetween.

The matching unit performs impedance matching by setting the plasma and the first and the second impedance adjusting circuit as a single load, and an output impedance of the matching unit is adjusted to a value higher than an impedance of the plasma by adjusting the impedances by the first and the second impedance adjusting circuit.

In accordance with a third aspect of the present invention, there is provided a substrate processing apparatus for processing a plurality of substrates by a plasma generated by a high frequency power, the apparatus including: a high frequency power supply configured to generate a high frequency power; a plurality of plasma generation electrodes corresponding to the substrates, respectively, each of plasma generation electrodes being configured to generate the plasma by the high frequency power supplied from the high frequency power supply; a single matching unit provided between the high frequency power supply and the plasma generation electrodes, and configured to match an impedance of a transmission path and an impedance of a load; and a plurality of impedance adjusting circuits provided between the matching unit and the respective plasma generation electrodes, and configured to adjust the impedances therebetween.

The matching unit performs impedance matching by setting the plasma and the impedance adjusting circuits as a single load, and an output impedance of the matching unit is adjusted to a value higher than an impedance of the plasma by adjusting the impedances by the plurality of impedance adjusting circuits.

In accordance with a fourth aspect of the present invention, there is provided a substrate processing apparatus for processing a substrate by a plasma generated by a high frequency power, the apparatus including: a high frequency power supply configured to generate a high frequency power; a plurality of plasma generation electrodes, each of which has a first power feed point and a second power feed point provided at an oppositely facing position to the first power feed point, and is configured to generate the plasma by the high frequency power supplied to the first power feed point and the second power feed point from the high frequency power supply; a single matching unit provided between the high frequency power supply and the plasma generation electrodes, and configured to match an impedance of a transmission path and an impedance of a load; a plurality of first impedance adjusting circuits each of which is provided between the matching unit and the corresponding first power feed point, and configured to adjust an impedance therebetween; and a plurality of second impedance adjusting circuits each of which is provided between the matching unit and the corresponding second power feed point, and configured to adjust an impedance therebetween.

The matching unit performs impedance matching by setting the plasma and the first impedance adjusting circuits and second impedance adjusting circuits as a single load, and an output impedance of the matching unit is adjusted to a value higher than an impedance of the plasma by adjusting the impedances by the first impedance adjusting circuits and the second impedance adjusting circuits.

In the second to fourth aspects, each of the impedance adjusting circuits or each of the first and second impedance adjusting circuits may have a single variable capacitor and one or more fixed capacitors. The impedance may be adjusted by using the variable capacitor, and the impedance may be finely adjusted by using the fixed capacitors. In this case, the fixed capacitors may be selectively connectable by selecting one or more of the fixed capacitors among the fixed capacitors.

In the first to fourth aspects, the output impedance of the matching unit may range from 20 e to 35 t.

In accordance with the first aspect of the present invention, the impedance adjusting circuit is provided between the single matching unit and the plasma generation electrode, and the impedance between the matching unit and the plasma generation electrode is adjusted by the impedance adjusting circuit. The matching unit performs impedance matching by setting the plasma and the impedance adjusting circuit as a single load, and the output impedance of the matching unit is adjusted to the value higher than the impedance of the plasma. Accordingly, an electric current flowing in the matching unit and an electric current flowing from the matching unit can be reduced to be small as compared to a conventional case. As a result, a heat generation or a power loss can be suppressed. Further, a variable capacitor designed for a lower current can be used, so that cost-effectiveness is high. Moreover, even if there is a variation in impedance due to a minute difference in assembling, such a variation of impedance can be reduced. Accordingly, a variation in the electric current is small, and a fluctuation in the power inputted to the electrode can also be reduced. Although a device dependent difference may also exist in the impedance adjusting circuit, such a difference can be adjusted by impedance adjustment performed by the impedance adjusting circuit.

In accordance with the second aspect of the present invention, the first impedance adjusting circuit is provided between the single matching unit and the first power feed point of the plasma generation electrode, and the second impedance adjusting circuit is provided between the single matching unit and the second power feed point of the plasma generation electrode provided at the oppositely facing position to the first power feed point. The matching unit performs impedance matching by setting the plasma and the first and the second impedance adjusting circuit as a single load, and the output impedance of the matching unit is adjusted to the value higher than the impedance of the plasma.

Accordingly, the same effects as obtained in the first aspect can also be achieved. Besides, even when the size of the electrode is enlarged to correspond to a large-size substrate, a uniform voltage distribution in the plasma generation electrode can be achieved without causing a power loss or a matching failure due to interference between matching units. That is, since the final impedance matching is performed by the single matching unit, a problem due to interference between matching units may not occur.

Further, since only one matching device using two high-price variable capacitors for high current is used, cost can be reduced. Furthermore, since the output impedance of the matching unit is high, a relatively low electric power can be supplied to the transmission paths, which are extended from the matching unit to the first and the second impedance adjusting circuit, respectively, and a power loss is small.

In addition, since it is possible to adjust the impedances by the first and the second impedance adjusting circuit, fluctuation in powers inputted from both ends of the plasma generation electrode can be effectively suppressed, and uniformity in the voltage distribution can be improved very high.

In accordance with a third aspect and a fourth aspect of the present invention, the substrate processing apparatuses described in the first and the second aspect are applied to a batch-type processing apparatus including a multiple number of plasma generation electrodes and configured to perform a process on a multiple number of substrates. In accordance with the third and the fourth aspect, non-uniformity in impedances between the plasma generation electrodes can also be adjusted.

### Brief Description of the Drawings

The objects and features of the present disclosure will become apparent from the following description of embodiments given in conjunction with the accompanying drawings, in which:
Fig. 1 is a cross sectional view illustrating a substrate processing apparatus in accordance with a first embodiment of the present invention;
Fig. 2 shows a circuit structure of a matching unit;
Fig. 3 shows a circuit structure of an impedance adjusting circuit;
Fig. 4 is a cross sectional view illustrating a substrate processing apparatus in accordance with a second embodiment of the present invention;
Fig. 5 is a cross sectional view illustrating a substrate processing apparatus in accordance with a third embodiment of the present invention; and
Fig. 6 is a cross sectional view illustrating a substrate processing apparatus in accordance with a fourth embodiment of the present invention.

### Detailed Description of the Embodiments

Hereinafter, embodiments of the present invention will be described with reference to the accompanying drawings which form a part hereof.

### (First embodiment)

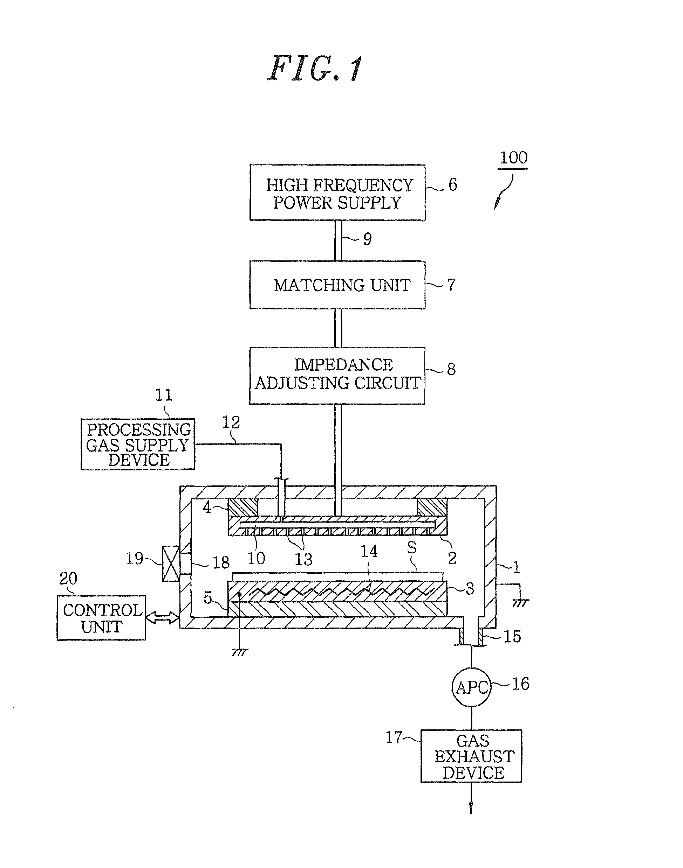

A first embodiment will now be described. Fig. 1 is a cross sectional view illustrating a substrate processing apparatus in accordance with the first embodiment of the present invention.

A substrate processing apparatus 100 is configured as a parallel plate type plasma processing apparatus that performs a plasma process on a substrate. The substrate processing apparatus 100 includes a chamber 1 for accommodating a substrate S and performing the plasma process therein. The chamber 1 is frame grounded.

A cathode electrode 2 and an anode electrode 3 serving as parallel plate electrodes are disposed in the chamber 1. The cathode electrode 2 is configured as an upper electrode and serves as a plasma generation electrode to which a high frequency power is applied. The cathode electrode 2 also serves as a shower head that introduces a processing gas into the chamber 1. Meanwhile, the anode electrode 3 is configured as a lower electrode and serves as a mounting table for mounting thereon the substrate S. The cathode electrode 2 is supported on a ceiling wall of the chamber 1 via an insulating member 4, and the anode electrode 3 is supported on a bottom wall of the chamber 1 via an insulating member 5. The anode electrode 3 is electrically grounded.

Further, the substrate processing apparatus 100 also includes a high frequency power supply 6 configured to supply a high frequency power (RF power) to the cathode electrode 2; a matching unit 7 configured to match an impedance of a load to an impedance of a transmission path; and an impedance adjusting circuit 8 configured to adjust an impedance. The matching unit 7 and the impedance adjusting circuit 8 are sequentially connected to a transmission path 9 with the matching unit 7 positioned on the side of the high frequency power supply 6. The transmission path 9 is made of a copper plate or a copper rod and extends from the high frequency power 6 to a center of a rear surface of the cathode electrode 2.

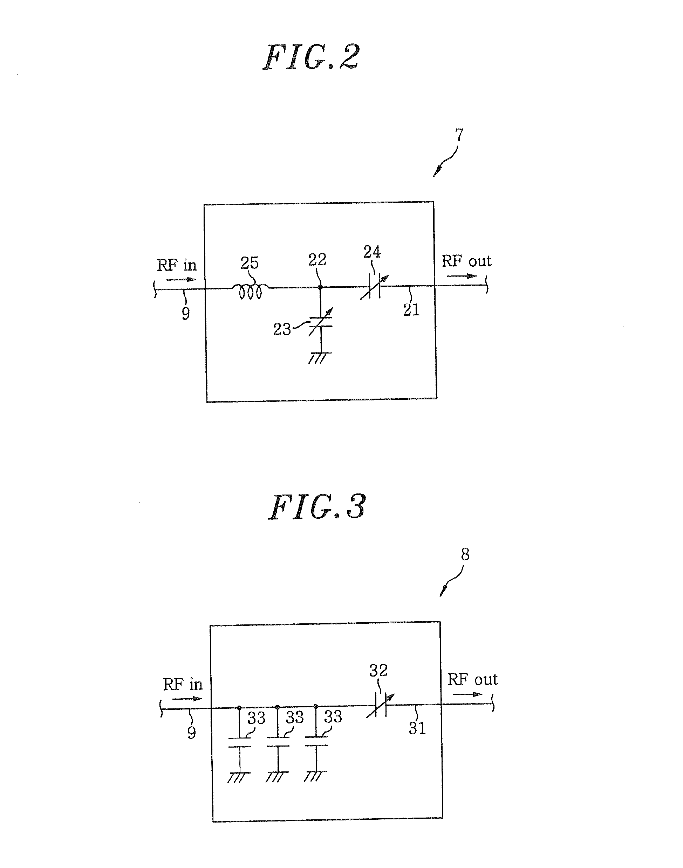

The matching unit 7 includes, as shown in Fig. 2, a transmission line 21 connecting an input side and an output side of the transmission path 9; a first variable capacitor 23 branched from a branch point 22 of the transmission line 21; a second variable capacitor 24 provided on an output side relative to the branch point 22 of the transmission line 21; and a coil (inductor) 25 provided on an input side relative to the branch point 22. The matching unit 7 is configured to automatically match an impedance (e.g., about 50 Ω) of the transmission path 9 and an impedance of the load by automatically adjusting positions (capacitances) of the first and the second variable capacitor 23 and 24.

The impedance adjusting circuit 8 includes, as shown in Fig. 3, a transmission line 31 connecting an input side and an output side of the transmission path 9; a variable capacitor (having a variable capacitance) 32 provided on the transmission line 31 and fixed capacitors (having fixed capacitances) 33. The variable capacitor 32 is used to change impedance and adjust a device dependent difference. The position (capacitance) of the variable capacitor 32 is manually adjusted. Further, fixed capacitors 33 are used to finely adjust variations in capacitances among high frequency paths or processing devices caused by minute differences in assembling methods for individual constituent parts of the high frequency circuit. By way of example, the fixed capacitors 33 are configured to be selectively connectable by a tap changer. One or more fixed capacitances can be selected as required. Further, although the three fixed capacitors 33 are shown in Fig 3, the number of the fixed capacitors may be one or more. In case of using only one fixed capacitor, the fixed capacitor may be configured to be turned on and off to adjust its capacitance. Further, the variable capacitor 32 may be only used if it is possible to perform fine control of capacitance with the variable capacitor 32 only.

The impedance adjusting circuit 8 adjusts an impedance between the matching unit 7 and the cathode electrode 2 mainly by using the variable capacitor 32. The impedance adjusting circuit 8 sets an input impedance to be of a value (e.g., in a range from 25 Ω to 40 Ω) higher than a plasma impedance, while setting an output impedance to be in the range from 1 Ω to several Ω corresponding to the plasma impedance. By providing the impedance adjusting circuit 8, the matching unit 7 performs matching by setting a plasma and the impedance adjusting circuit 8 as a single load, and an output impedance of the matching unit 7 can be adjusted by the impedance adjusting circuit 8 to have a preset impedance, e.g., ranging from 20 Ω to 35 Ω, which is higher than the plasma impedance, unlike in a conventional case where an output impedance is close to the plasma impedance ranging from 1 Ω to several Ω. That is, since the impedance of the load to be matched is set to be higher than that of a conventional case, an output current from the matching unit 7 can be reduced as compared to the conventional case.

Further, when a plasma is generated, an impedance of the plasma can be calculated through a process of performing impedance matching in a certain matching unit, obtaining a capacitance of a variable capacitor when the impedance is adjusted and measuring an impedance from outside while maintaining a state where the certain matching unit is separated from the chamber. That is, since the impedance measured in this way is a conjugate impedance of the plasma impedance, the plasma impedance can be simply calculated from this conjugate impedance.

A gas diffusion space 10 is formed in the cathode electrode 2. A processing gas is supplied into the gas diffusion space 10 from a processing gas supply device 11 via a gas supply line 12 and then is injected through a multiple number of gas injection holes 13 in a shower-like manner. The gas injection holes 13 are extended downward from the gas diffusion space 10 in the cathode electrode 2.

A heater 14 is embedded in the anode electrode 3. The heater 14 generates heat by a power supplied thereto from a non-illustrated power supply. Accordingly, the substrate S on the anode electrode 3 is heated to a preset temperature.

A gas exhaust line 15 for evacuating the inside of the chamber 1 is connected to a bottom portion of the chamber 1. An automatic pressure control valve (APC) 16 and a gas exhaust device 17 are provided on the gas exhaust line 15. While controlling an internal pressure of the chamber 1 by the automatic pressure control valve (APC) 16, the inside the chamber 1 is evacuated to a preset vacuum atmosphere by the gas exhaust device 17.

Provided in a sidewall of the chamber 1 is a loading/unloading port 18 through which the substrate S is loaded into and unloaded from the chamber 1. The loading/unloading port 18 can be opened and closed by a gate valve 19.

Individual components of the substrate processing apparatus 100 are controlled by a control unit (computer) 20. The control unit 20 includes a controller having a microprocessor; a user interface including a keyboard through which an operator inputs commands or the like to manage the substrate processing apparatus 100 and a display that visually displays an operational status of the substrate processing apparatus 100; and a storage unit that stores therein control programs for implementing various processes in the substrate processing apparatus 100 under the control of the controller, and/or processing recipes for implementing a certain process in the substrate processing apparatus 100 based on processing conditions. The processing recipes are stored in a storage medium, and are executed after being read from the storage medium in the storage unit. The storage medium may be a hard disk or a semiconductor memory, or a portable medium such as a CD-ROM, a DVD or a flash memory. If necessary, a recipe is read out from the storage unit in response to an instruction from the user interface and is executed by the controller, so that a required process is performed in the substrate processing apparatus 100 under the control of the controller.

In the substrate processing apparatus 100 configured as described above, after the gate valve 19 is opened, a substrate S is loaded into the chamber through the loading/unloading port 18 by a transfer device (not shown), and is mounted on the anode electrode 3 serving as the mounting table. Then, the transfer device is retreated from the chamber 1, and after closing the gate valve 19, the inside of the chamber 1 is evacuated by the gas exhaust device 17, so that the inside of the chamber is turned into a preset vacuum atmosphere. At this time, the substrate S on the anode electrode 3 is heated to a certain temperature by the heater 14. A processing gas is supplied into the gas diffusion space 10 of the cathode electrode 2 from the processing gas supply device 11 through the gas supply line 12. Then, the processing gas is injected in a shower-like manner through the gas injection holes 13 formed in the bottom surface of the cathode electrode 2, and a high frequency power is supplied to the cathode electrode 2 from the high frequency power supply 6 via the matching unit 7 and the impedance adjusting circuit 8.

As a result, a high frequency electric field is formed between the cathode electrode 2 and the anode electrode 3 disposed to face each other. A plasma of the processing gas is generated by the high frequency electric field, and a predetermined plasma process such as a plasma CVD is performed on the substrate S by this plasma of the processing gas.

At this time, in case that the substrate S is a large-size substrate for use in a solar cell panel or a flat panel, the power level of the high frequency power supplied from the high frequency power supply 6 may be high. If a conventional matching unit configured to perform an impedance matching to a low impedance, i.e., a plasma impedance ranging from about 1 Ω to several Ω, is used, an electric current flowing in the matching unit and an electric current from the matching unit may be increased extremely high, most likely resulting in a heat generation or a power loss. Furthermore, since a variable capacitor for high current needs to be used, there will result in a cost increases.

In addition, if an output impedance is as low as specified above, even a slight difference in impedance due to a minute difference in assembling of the matching unit or the transmission path may cause a great variation in impedance. That is, in a manufacturing process of the matching unit, an impedance variation of about 0.5 Ω may be easily resulted due to a device dependent difference in the matching unit 7 because of a difference in materials or object variance between components such as screws. If the output impedance is about 1 Ω, as in the conventional case, a variation ratio becomes as high as about 50%. Such a great variation in impedance leads to a great variation in electric current, which in turn results in a great variation in power inputted to the cathode electrode, thus affecting properties of products.

In contrast, in accordance with the first embodiment, the impedance adjusting circuit 8 is provided between the matching unit 7 and the cathode electrode 2 serving as the plasma generation electrode, and the impedance between the matching unit 7 and the cathode electrode 2 is adjusted by the variable capacitor 32 of the impedance adjusting circuit 8. Since the matching unit 7 performs impedance matching while setting the plasma and the impedance adjusting circuit 8 as a single load, the output impedance of the matching unit 7 can be set to a certain value, e.g., ranging from about 20 Ω to 35 Ω, which is higher than the plasma impedance. Accordingly, the electric current flowing in the matching unit 7 and the electric current flowing from the matching unit 7 can be reduced to be small as compared to the conventional case. As a result, a heat generation or a power loss may be suppressed. Further, a variable capacitor designed for a lower current can be used, so that cost-effectiveness is high.

Moreover, even if there is a variation in impedance due to a minute difference in assembling, such a variation of impedance can be reduced. That is, in case where the output impedance of the matching unit 7 is set to about 30 Ω, the variation of the impedance may be small, just about 2%, even if there is an impedance variation of about 0.5 Ω due to a device dependent difference in the matching unit. Accordingly, a variation in the electric current is small, and a fluctuation in power inputted to the electrode can also be reduced. Although a device dependent difference may also exist in the impedance adjusting circuit 8, such a difference can be adjusted by controlling the capacitance of the variable capacitor 32 or by finely controlling the capacitance of the fixed capacitors 33 by selectively connecting the fixed capacitors 33 or turning on and off the fixed capacitors 33.

Further, since the impedance of the transmission path 9 is about 50 Ω, it may be unnecessary to set the output impedance of the matching unit 7 to be larger than about 50 Ω. The output impedance is set to be smaller than about 50 Ω.

### (Second embodiment)

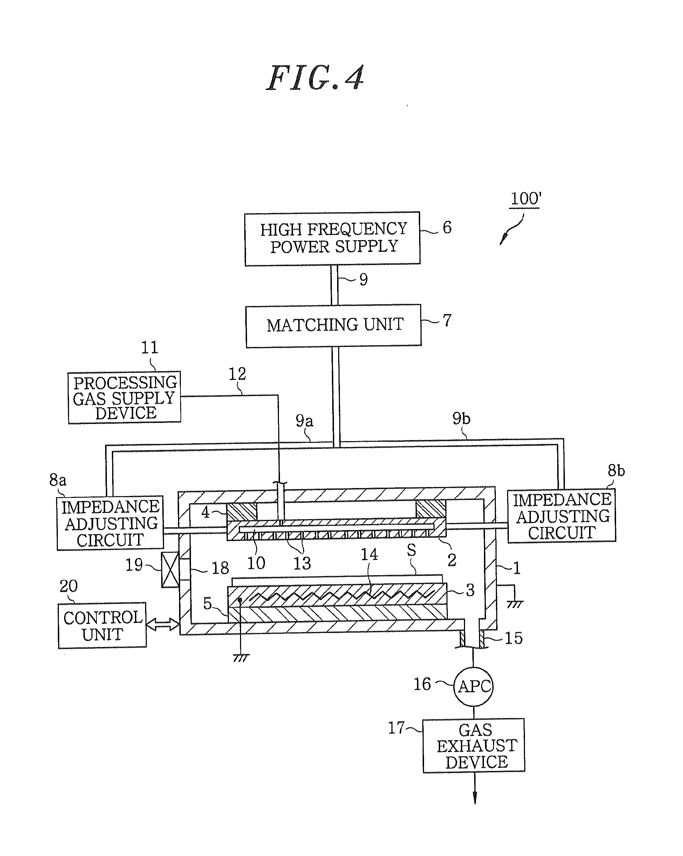

Now, a second embodiment will now be explained. Fig. 4 is a schematic configuration view of a substrate processing apparatus in accordance with the second embodiment of the present invention. A basic configuration of a substrate processing apparatus 100' in accordance with the second embodiment is the same as that of the substrate processing apparatus 100 of the first embodiment. Thus, in Fig. 4, like reference numerals will be given to like parts as those in Fig. 1, and redundant description thereof will be omitted.

The second embodiment is different from the first embodiment in that two impedance adjusting circuits 8a and 8b are provided, and a power is supplied to the cathode electrode 2 at two opposite power feed points (a first and a second power feed point) of the cathode electrode 2 via the impedance adjusting circuits 8a and 8b.

To elaborate, a transmission path 9 extended downward from a matching unit 7 is branched into transmission paths 9a and 9b, and these branch transmission paths 9a and 9b are connected to the two opposite power feed points of the cathode electrode 2 facing each other. The impedance adjusting circuits 8a and 8b are provided on the transmission paths 9a and 9b, respectively. The configuration of each of the impedance adjusting circuits 8a and 8b is the same as that of the impedance adjusting circuit 8. In this second embodiment, in order to adjust a difference in impedance between the two impedance adjusting circuits 8a and 8b, at least one fixed capacitor 33 capable of being selectively connected or turned on/off is used.

In the substrate processing apparatus 100' in accordance with the second embodiment, a plasma process such as plasma CVD is performed, as in the substrate processing apparatus 100 in accordance with the first embodiment. Further, as in the first embodiment, impedances are adjusted by using variable capacitors of the impedance adjusting circuits 8a and 8b to set an output impedance of the matching unit 7 to be of a value higher than an impedance of plasma. Accordingly, an electric current flowing in the matching unit 7 and an electric current flowing from the matching unit 7 can be reduced as compared to the conventional case, so that a heat generation or a power loss can be suppressed. Furthermore, variable capacitors designed for lower currents may be used, and, thus, cost-effectiveness can be improved.

Further, even if there is a variation in impedance due to a device dependent difference in the matching unit 7, the variation of impedance can be minimized. Accordingly, a variation in electric current becomes also small, so that a fluctuation in power inputted to the electrode can be reduced. In addition, device dependent differences in the impedance adjusting circuits 8a and 8b can be adjusted by controlling capacitances of their variable capacitors or by finely controlling capacitances of the fixed capacitors by selectively connecting the fixed capacitors or turning on and off the fixed capacitors.

In addition to the aforementioned effects, the following effect can also be obtained in accordance with the second embodiment. That is, in accordance with the second embodiment, even when the size of the electrode is enlarged to correspond to a large-size substrate, a uniform voltage distribution to the cathode electrode can be achieved without causing a power loss or a matching failure due to interference between matching units.

Specifically, as a technique to uniform the voltage distribution of an electrode (cathode electrode), in case of supplying a power to both ends of the cathode electrode via respective matching units as in Japanese Patent Application Publication No. 2001-274099, the two matching units are coupled to the single load and, thus, a matching failure may occur due to interference therebetween. Further, apparatus cost increases due to the increase of the number of the matching units, each of which includes two high-price variable capacitors for high current.

Meanwhile, as in Japanese Patent Application Publication No. 2000-003878, in case of supplying a power to both ends of the electrode after branching the power from a single matching unit, the length of the path from the matching unit to the electrode is long and the path has a low impedance. Resultantly, the length of the path through which a high frequency power of a high power level flows is long, and a power loss may be extremely increased.

In contrast, in accordance with the present embodiment, since the final impedance matching is performed by the single matching unit 7, the problem due to interference between matching units will not occur. Further, since only one matching device using two high-price variable capacitors for high current is used, cost can be reduced. Furthermore, since the output impedance of the matching unit 7 is high, a relatively low power can be supplied to the transmission paths 9a and 9b, which are extended from the matching unit 7 to the impedance adjusting circuits 8a and 8b, respectively, and a power loss is small.

In addition, since it is possible to perform fine control of impedance by using the fixed capacitors of the impedance adjusting circuits 8a and 8b, fluctuation in powers inputted from both ends of the cathode electrode 2 can be suppressed effectively, and uniformity in the voltage distribution can be improved very high. In this way, while solving the problems of the techniques disclosed in Japanese Patent Application Publication Nos. 2001-274099 and 2000-003878, it is possible to supply high frequency powers uniformly to both ends of the cathode electrode 2. Even when a large-size electrode is used, the uniform voltage distribution can be achieved.

### (Third embodiment)

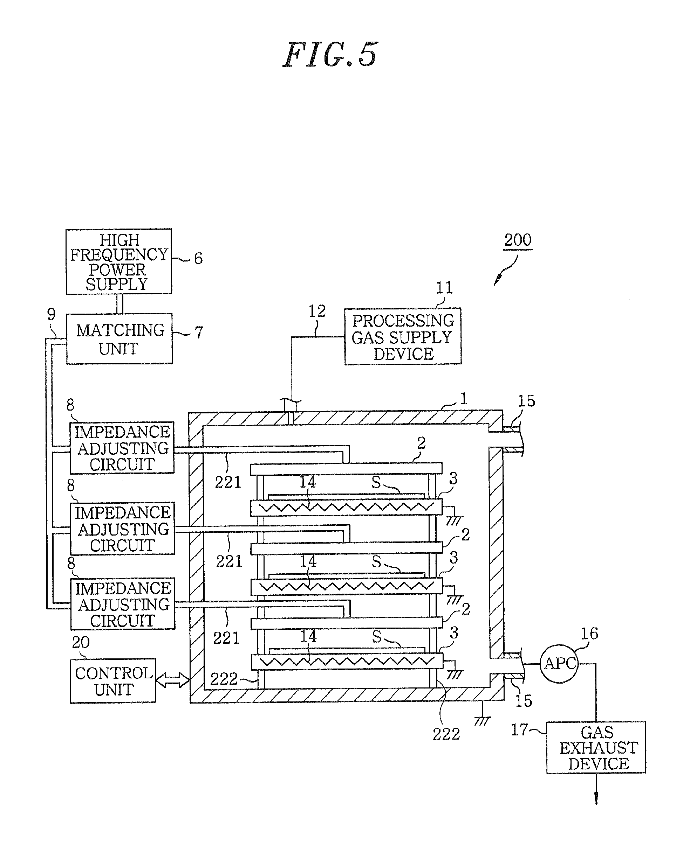

Now, a third embodiment will now be explained. Fig. 5 is a schematic configuration view of a substrate processing apparatus in accordance with the third embodiment of the present invention. Basically, a substrate processing apparatus 200 of the third embodiment is embodied by applying the substrate processing apparatus 100 of the first embodiment to an apparatus (batch type apparatus) that perform a plasma process on a multiple number of substrates. Thus, like reference numerals will be given to like parts having the same functions as those in Fig. 1, and redundant description thereof will be omitted.

The substrate processing apparatus 200 is configured as a parallel plate type plasma processing apparatus that performs a plasma process on a multiple number of substrates. The substrate processing apparatus 200 includes a chamber 1 for accommodating the multiple number of (e.g., three in Fig. 5) substrates S and performing the plasma process therein. As in the first embodiment, the chamber 1 is frame grounded.

In the chamber 1, pairs of parallel plate electrodes are arranged in a vertical direction, and each pair includes a cathode electrode 2 and an anode electrode 3 arranged to face each other in the vertical direction. In Fig. 5, for example, three pairs of parallel plate electrodes are provided. The anode electrode 3 is configured as a lower electrode. As in the substrate processing apparatus 100, the anode electrode 3 serves as a mounting table for mounting a substrate S thereon and is electrically grounded. The anode electrode 3 includes a heater 14 embedded therein. The cathode electrode 2 is configured as an upper electrode and serves as a plasma generation electrode to which a high frequency power is supplied. Unlike in the first embodiment, however, the cathode electrode 2 does not have a function as a shower head.

The cathode electrode 2 and the anode electrode 3 are supported in the chamber 1 by a supporting member 222. Further, by providing an elevating device and moving the cathode electrode 2 or anode electrode 3 up and down, a distance between the cathode electrode 2 and the anode electrode 3 may be adjustable.

Similarly to the substrate processing apparatus 100, the substrate processing apparatus 200 further includes a high frequency power supply 6 configured to supply a high frequency power (RF power) to the cathode electrode 2; a matching unit 7 configured to match an impedance of a load to an impedance of a transmission path; and impedance adjusting circuits 8 configured to change an impedance. Here, one high frequency power supply 6 is provided and one matching unit 7 is provided. A transmission path 9 made of a copper plate or a copper rod is extended from the high frequency power supply 6, and the matching unit 7 is connected to the transmission path 9. Further, the transmission path 9 is branched into transmission paths 221, and the transmission paths 221 are connected to centers of top surfaces of the corresponding cathode electrode 2, respectively. The impedance adjusting circuits 8 are provided on the transmission paths 221 so as to correspond to the cathode electrodes 2, respectively. That is, a high frequency power from the common high frequency power supply 6 is supplied to the respective cathode electrodes 2 via the common matching unit 7 after its impedance is adjusted by the impedance adjusting circuits 8 that are provided to correspond to the cathode electrodes 2, respectively.

In this third embodiment, a gas supply line 12 extended from a processing gas supply device 11 is connected to a ceiling wall of the chamber 1. Here, it may be also possible to configure the cathode electrodes 2 to serve as shower heads, thus allowing a processing gas to be introduced from the respective cathode electrodes in a shower-like manner.

A gas exhaust line 15 is connected to an upper sidewall portion and a lower sidewall portion of the chamber 1. An automatic pressure control value (APC) 16 and a gas exhaust device 17 are provided on the gas exhaust line 15. While controlling an internal pressure of the chamber 1 by the APC 16, the inside of the chamber 1 is evacuated to a preset vacuum atmosphere by the gas exhaust device 17.

Provided in a sidewall of the chamber 1 is a loading/unloading port (not shown) through which the substrates S are loaded into and unloaded form the chamber 1 all together. The loading/unloading port can be opened and closed by a gate valve (not shown).

As in the substrate processing apparatus 100 in accordance with the first embodiment, individual components of the substrate processing apparatus 200 are controlled by a control unit (computer) 20.

In the substrate processing apparatus 200 of the third embodiment, a plasma process such as plasma CVD is performed in the same manner as in the substrate processing apparatus 100 of the first embodiment. That is, the multiple number of (e.g., three) substrates S are respectively loaded on the anode electrodes 3. Then, by evacuating the chamber 1, the inside of the chamber is turned into a vacuum atmosphere. While heating the substrates S by using the heaters 14 to a preset temperature, a processing gas is introduced into the chamber 1 from the processing gas supply device 11 through the gas supply line 12. Further, a high frequency power is supplied to the cathode electrodes 2 from the common high frequency power 6 via the common matching unit 7 and the impedance adjusting circuits 8 corresponding to the cathode electrodes 2, respectively.

Accordingly, in each pair of parallel plate electrodes, a high frequency electric field is formed between the cathode electrode 2 and the anode electrode 3 facing each other. A plasma of the processing gas is generated by the high frequency electric field, and the preset plasma process such as plasma CVD is performed on the substrate S by this plasma.

In accordance with the third embodiment, the impedance adjusting circuits 8 are provided, and impedances are adjusted by the variable capacitors 32 of the impedance adjusting circuits 8. Since an output impedance of the matching unit 7 is set to be higher than an impedance of plasma, an electric current flowing in the matching unit 7 and an electric current flowing from the matching unit 7 can be reduced to be small as compared to the conventional case. As a result, a heat generation or a power loss may be suppressed. Further, since a variable capacitor for a lower current can be used, cost-effectiveness is high.

Moreover, even if there is a variation in impedance due to a device dependent difference in the matching unit 7 or the transmission path, such a variation in impedance can be minimized. Further, in the present embodiment, since the multiple number of cathode electrodes 2 are used, there may be generated a difference in plasma impedance between the electrodes depending on a relative position of each cathode electrode 2 and a chamber wall. Although such a difference may affect properties of products, the difference in impedance between the cathode electrodes 2 can be adjusted through a fine control of capacitance by way of selectively connecting or turning on and off fixed capacitors 33 of the impedance adjusting circuits 8 coupled to the cathode electrodes 2, respectively. Thus, discrepancies in the properties of the products can be suppressed.

### (Fourth embodiment)

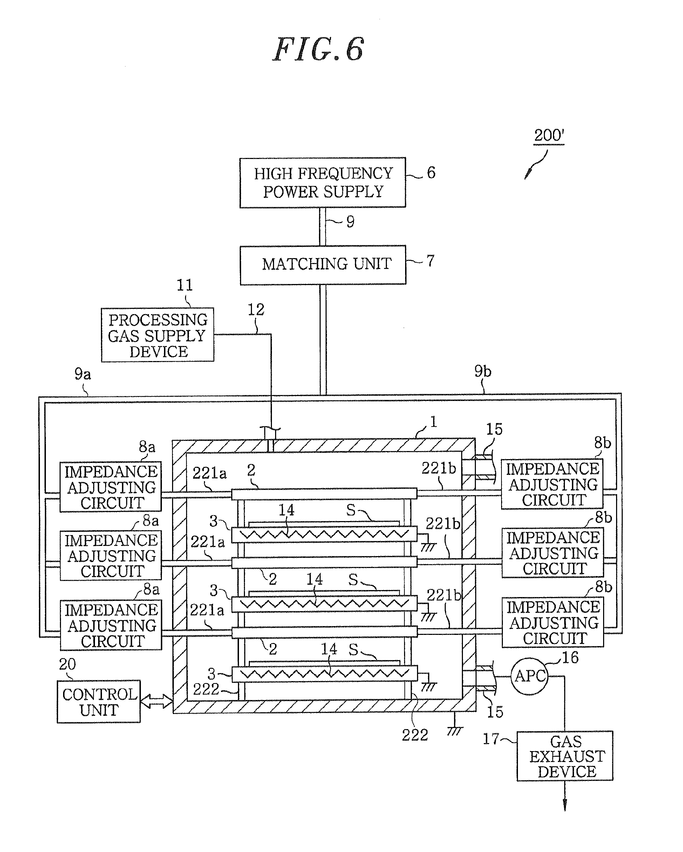

Now, a fourth embodiment will now be explained. Fig. 6 is a schematic configuration view of a substrate processing apparatus in accordance with the fourth embodiment of the present invention. Basically, a substrate processing apparatus 200' in accordance with the fourth embodiment is embodied by applying the substrate processing apparatus 100' of the second embodiment to an apparatus (batch type apparatus) that perform a plasma process on a multiple number of substrates. Thus, like reference numerals will be given to like parts having the same functions as those of the parts in Figs. 4 and 5, and redundant description thereof will be omitted.

This fourth embodiment is different from the third embodiment in that two impedance adjusting circuits 8a and 8b are provided for each cathode electrode 2, and a power is supplied to the cathode electrode 2 from two opposite ends thereof via the impedance adjusting circuits 8a and 8b, respectively.

To elaborate, a transmission path 9 extended from a common high frequency power supply 6 disposed above a chamber 1 via a common matching unit 7 disposed below the high frequency power supply 6 is branched into transmission paths 9a and 9b. The transmission paths 9a and 9b are extended downward along the two opposite sides of the sidewall of the chamber 1. Transmission paths 221a branched from the transmission path 9a are respectively connected to one ends of cathode electrodes 2 via individual impedance adjusting circuits 8a, and transmission paths 221b branched from the transmission path 9b are respectively connected to the other ends of the cathode electrodes 2 via individual impedance adjusting circuits 8b. That is, a high frequency power from the common high frequency power supply 6 is supplied to each cathode electrode 2 from the two opposite ends thereof while impedances are adjusted by the impedance adjusting circuit 8a provided at one of the cathode electrode 2 and by the impedance adjusting circuit 8b provided at the other end of the cathode electrode 2 after passing through the common matching unit 7.

In the substrate processing apparatus 200' in accordance with the fourth embodiment, as in the substrate processing apparatus 200 of the third embodiment, a multiple number of (e.g., three) substrates S are mounted on the anode electrodes 3, and while the substrates S are heated by heaters 14 to a preset temperature, a processing gas is introduced into the chamber 1. Further, a high frequency power is supplied to each cathode electrode 2 from the common high frequency power supply 6 via the common matching unit 7 and the impedance adjusting circuits 8a and 8b provided to correspond to the two opposite ends of each cathode electrode 2. Accordingly, a plasma process such as plasma CVD is performed on each substrate S by a plasma of the processing gas generated between the cathode electrode 2 and the anode electrode 3 in each pair of parallel plate electrodes.

In the substrate processing apparatus 200' in accordance with the present embodiment, an output impedance of the matching unit 7 is set to be higher than a plasma impedance by adjusting impedances by variable capacitors of the impedance adjusting circuits 8a and 8b, so that an electric current flowing in the matching unit 7 and an electric current flowing from the matching unit 7 can be reduced to be smaller than those in the conventional case. Therefore, a heat generation or a power loss can be suppressed. Further, variable capacitors designed for lower currents may be used, and, thus, cost-effectiveness can be improved. Furthermore, even if there is a variation in impedance due to a device dependent difference in the matching unit 7 or the transmission paths, the variation of impedance can be minimized.

Moreover, in the present embodiment, since the final impedance matching is implemented by the single matching unit 7, a problem due to interference between matching units will not occur. Further, since only one matching device using two high-price variable capacitors for high current is used, cost can be reduced. Furthermore, since the output impedance of the matching unit 7 is high, a relatively low electric current can be supplied to the transmission paths 9a and 9b, which are extended from the matching unit 7 to the impedance adjusting circuits 8a and 8b, respectively, and a power loss is small. In addition, since it is possible to perform fine control of impedance by fixed capacitors 33 of the impedance adjusting circuits 8a and 8b, fluctuation in powers inputted from both ends of each cathode electrode 2 can be minimized effectively. Further, uniformity of a voltage distribution can be further improved, and discrepancies in properties of products can be suppressed.

### (Modification example)

The present invention is not limited to the above-described embodiments but can be modified in various ways. By way of example, in the above-described embodiments, the variable capacitor of the impedance adjusting circuit is configured to have impedance to be manually adjusted such that an input impedance becomes a preset value higher than a plasma impedance and an output impedance becomes a certain value corresponding to the plasma impedance. However, the variable capacitor of the impedance adjusting circuit may be configured to have the impedance to be adjusted automatically, thus having it to perform a part of the function of an automatic variable capacitor of the matching unit and extending the matching range.

Further, the substrate processing apparatuses have been described for the case of performing a plasma CVD process as a plasma process. However, the illustrative embodiments may not be limited thereto but may be applied to other plasma processes such as a plasma etching process. Further, in the above-described embodiments, a high frequency power is introduced to the upper electrode of the parallel plate electrodes while the lower electrode is grounded. Alternatively, however, the upper electrode may be grounded and a high frequency power may be supplied to the lower electrode. Further, it may be also possible to apply high frequency powers to both the upper electrode and the lower electrode. Further, when the illustrative embodiments are applied to a batch type apparatus, the number of substrates processed at one time may not be limited to three. Further, the substrate used in the illustrative embodiments may not be particularly limited. That is, the illustrative embodiments may be applicable to various types of substrates such as a solar cell substrate, a glass substrate for a flat panel display (FPD), and the like.

While the invention has been shown and described with respect to the embodiments, it will be understood by those skilled in the art that various changes and modification may be made without departing from the scope of the invention as defined in the following claims.

## Claims

1. A substrate processing apparatus for processing one or more substrates by a plasma generated by a high frequency power, the apparatus comprising:
a high frequency power supply configured to generate a high frequency power;
one or more plasma generation electrodes corresponding to the substrates, respectively, each of plasma generation electrodes being configured to generate the plasma by the high frequency power supplied from the high frequency power supply;
a single matching unit provided between the high frequency power supply and the plasma generation electrodes, and configured to match an impedance of a transmission path and an impedance of a load; and
one or more impedance adjusting circuits provided between the matching unit and the respective plasma generation electrodes, and configured to adjust impedances therebetween,
wherein the matching unit performs impedance matching by setting the plasma and the impedance adjusting circuits as a single load, and an output impedance of the matching unit is adjusted to a value higher than an impedance of the plasma by adjusting the impedance or the impedances by the impedance adjusting circuits.

2. The substrate processing apparatus of claim 1,
wherein each of the impedance adjusting circuits has a single variable capacitor to adjust the impedance by using the variable capacitor.

3. The substrate processing apparatus of claim 2,
wherein each of the impedance adjusting circuits further has one or more fixed capacitors to perform a fine adjustment of the impedance by using the fixed capacitors.

4. The substrate processing apparatus of claim 3,
wherein the fixed capacitors are selectively connectable by selecting one or more of the fixed capacitors among the fixed capacitors.

5. The substrate processing apparatus of claim 1,
wherein each of the plasma generation electrodes has a first power feed point and a second power feed point provided at an oppositely facing position to the first power feed point, and is configured to generate the plasma by the high frequency power supplied to the first power feed point and the second power feed point from the high frequency power supply;
wherein the impedance adjusting circuits include one or more first impedance adjusting circuits each of which is provided between the matching unit and the corresponding first power feed point, and is configured to adjust an impedance therebetween; and one or more second impedance adjusting circuits each of which is provided between the matching unit and the corresponding second power feed point, and is configured to adjust an impedance therebetween; and
wherein the matching unit performs impedance matching by setting the plasma and the first impedance adjusting circuits and the second impedance adjusting circuits as a single load, and an output impedance of the matching unit is adjusted to a value higher than an impedance of the plasma by adjusting the impedances by the first impedance adjusting circuits and the second impedance adjusting circuits.

6. The substrate processing apparatus of claim 1,
wherein the plasma generation electrodes are provided in a plural number; and
wherein each of the impedance adjusting circuits is provided between the matching unit and each of the plasma generation electrodes.

7. The substrate processing apparatus of claim 5,
wherein the plasma generation electrodes are provided in a plural number.

8. The substrate processing apparatus of any one of claims 5 to 7,
wherein each of the impedance adjusting circuits or each of the first and second impedance adjusting circuits has a single variable capacitor and one or more fixed capacitors,
the impedance is adjusted by using the variable capacitor, and
the impedance is finely adjusted by using the fixed capacitors.

9. The substrate processing apparatus of claim 8,
wherein the fixed capacitors are selectively connectable by selecting one or more of the fixed capacitors among the fixed capacitors.

10. The substrate processing apparatus of any one of claims 1 to 9,
wherein the output impedance of the matching unit ranges from 20 e to 35 Ω.
